# EUROPEAN PATENT APPLICATION

(11) **EP 4 169 971 A1**
(43) Date of publication of application: **26.04.2023**
(21) Application number: 21829982.4
(22) Date of filing: 18.06.2021
(51) Int. Cl.: C08G 77/04, C08G 77/44, C08L 83/10, H01L 21/02, H01L 21/312, H01L 21/60, H01L 21/768, H01L 23/532, H01L 27/146, B32B 7/025

(54) **LAMINATE, CURABLE RESIN COMPOSITION, METHOD FOR MANUFACTURING LAMINATE, METHOD FOR MANUFACTURING SUBSTRATE HAVING JUNCTION ELECTRODE, SEMICONDUCTOR DEVICE, AND IMAGE CAPTURING DEVICE**

(30) Priority: 22.06.2020 JP 2020107273
(71) Applicant: SEKISUI CHEMICAL CO., LTD., 530-0047 (JP)
(72) Inventor: SHIOJIMA, Taro, Mishima-gun, Osaka 618-0021 (JP); SATO, Kenichiro, Mishima-gun, Osaka 618-0021 (JP); DEGUCHI, Hidenobu, Mishima-gun,, Osaka 618-0021 (JP); ISHIZAWA, Hideaki, Mishima-gun, Osaka 618-0021 (JP); HATAI, Munehiro, Mishima-gun, Osaka 618-0021 (JP); SHICHIRI, Tokushige, Mishima-gun, Osaka 618-0021 (JP)
(74) Representative: Cabinet Beau de Loménie
(86) International application number: PCT/JP2021/023227
(87) International publication number: WO 2021/261403

(57) **Abstract**

The present invention aims to provide a stack having high electrical connection reliability, a curable resin composition used for the stack, a method for producing the stack, a method for producing a substrate having a bonding electrode used for producing the stack, a semiconductor device including the stack, and an imaging device including the stack. Provided is a stack sequentially including: a first substrate having an electrode; an organic film; and a second substrate having an electrode, the electrode of the first substrate and the electrode of the second substrate are electrically connected via a through-hole extending through the organic film.

## Description

### TECHNICAL FIELD

The present invention relates to a stack having high electrical connection reliability, a curable resin composition used for the stack, a method for producing the stack, a method for producing a substrate having a bonding electrode used for producing the stack, a semiconductor device including the stack, and an imaging device including the stack.

### BACKGROUND ART

With the increase in performance of semiconductor devices, 3D stacking of multiple semiconductor chips has made progress. The production of such a stack of multiple semiconductor chips first includes the formation of bonding surfaces, which consist of copper-made bonding electrodes surrounded by an insulating film, by the damascene process on the electrode surfaces of two substrates having electrodes formed thereon. The two substrates are then stacked on top of each other such that the bonding electrodes of the bonding surfaces face each other, and then heat-treated to produce a stack (Patent Literature 1).

### CITATION LIST

### - Patent Literature

Patent Literature 1: JP 2006-191081 A

### SUMMARY OF INVENTION

### - Technical problem

Bonding of the electrodes in the production of the stack involves high-temperature processing at 400°C for four hours. The insulating films used for the bonding surfaces thus require high heat resistance. Conventional stacks therefore include an insulating inorganic material such as SiN or SiO₂ as an insulator. However, insulating films made of inorganic materials tend to cause warping of the substrates. A warped substrate may cause misalignment of the electrode connecting positions or cracking of electrodes in the stack to be obtained. This may reduce the connection reliability of the stack. As the performance of semiconductor devices has increased in recent years, substrates have been becoming larger and thinner, and thus becoming more susceptible to warping.

The present invention aims to provide a stack having high electrical connection reliability, a curable resin composition used for the stack, a method for producing the stack, a method for producing a substrate having a bonding electrode used for producing the stack, a semiconductor device including the stack, and an imaging device including the stack.

### - Solution to problem

The present invention relates to a stack sequentially including: a first substrate having an electrode; an organic film; and a second substrate having an electrode, the electrode of the first substrate and the electrode of the second substrate being electrically connected via a through-hole extending through the organic film. The present invention is described in detail below.

The stack of the present invention sequentially includes a first substrate having an electrode, an organic film, and a second substrate having an electrode. The electrode of the first substrate (first electrode) and the electrode of the second substrate (second electrode) are electrically connected via a through-hole extending through the organic film.

The organic film provided between the first electrode and the second electrode serve as an insulating layer to reduce short circuiting of current. A conventional insulating layer contains a hard inorganic material such as SiN or SiO₂, and thus warping that occurs in the formation of the insulating layer or in the formation of the stack cannot be eliminated by stress relaxation. As a result, misalignment or cracking of electrodes tends to occur. In the present invention, an organic film, which is more flexible than an inorganic material film, is used as the insulating layer. This leads to high electrical connection reliability. In particular, warping of the substrates or the stack that has occurred can be eliminated, so that even when thin substrates, which are more susceptible to warping, are stacked, the resulting stack can have high electrical connection reliability and causes less misalignment or cracking of electrodes. Moreover, conventional insulating layers take time to produce because they are formed by vapor deposition. However, the organic film of the stack of the present invention can be formed by applying and curing a curable resin, for example, thus increasing production efficiency.

The "electrically connected" as used herein means a state in which the electrode of the first substrate and the electrode of the second substrate are connected via a conductive material or the like filling the through-hole.

The first substrate and the second substrate are not limited, and each may be a circuit board having elements, wires, and electrodes formed thereon. For example, the first substrate and the second substrate each may be a sensor circuit board provided with a pixel portion (pixel region) or a circuit board mounted with a peripheral circuit portion such as a logic circuit that implements various types of signal processing related to the operation of a solid-state imaging device, for example.

The materials of the electrodes of the first substrate and the second substrate and the conductive material are not limited. Conventional electrode materials such as gold, copper, and aluminum may be used.

The organic film may be any layer that contains an organic compound as a material. The organic film is preferably a layer containing a resin as a material. The organic film may contain a component other than the resin material as long as the effects of the present invention are not significantly impaired. In this case, the amount of the resin material in the organic film is, for example, preferably 90% by weight or more, more preferably 95% by weight or more, still more preferably 99% by weight or more, typically less than 100% by weight.

The resin material may be an organosilicon compound, a polysiloxane resin, or the like as described later.

The organic film preferably has a weight loss of 5% or less after heat treatment at 400°C for four hours.

The organic film having a weight loss within the range after heat treatment enables more secure bonding of the substrates and can further reduce generation of air bubbles and cracks at the interface or delamination at the interface that are caused by the decomposition of the organic film in bonding the electrodes. The weight loss is more preferably 3% or less, still more preferably 1% or less. The lower limit of the weight loss is not limited. The closer to 0%, the better, but the limit is about 0.5% from the standpoint of the manufacturing technique.

The weight loss after heat treatment at 400°C for four hours can be adjusted by adjusting factors such as the composition of the organic film, the type of the resin material constituting the organic film, and curing conditions in the production of the organic film.

Specifically, for example, as for the composition of the organic film, using a highly heat resistant resin material or an inorganic component or increasing the amount of a crosslinking agent can reduce the weight loss after heat treatment at 400°C for four hours.

As for the type of the resin material constituting the organic film, using a highly heat resistant resin (e.g., resin having high molecular weight, resin having a highly heat resistant backbone or substituent, or an organosilicon compound described later) can reduce the weight loss after heat treatment at 400°C for four hours. As for the curing conditions for the curable resin composition constituting the organic film, using high temperature to allow curing to sufficiently proceed or prolonging the curing time can reduce the weight loss after heat treatment at 400°C for four hours.

The organic film preferably has a surface hardness of 5 GPa or less as measured using a nanoindenter.

The organic film having a surface hardness within the range has high flexibility, which makes the substrates and the stack even less susceptible to warping. Moreover, such an organic film makes it easier to eliminate warping that has occurred, so that misalignment or cracking of electrodes can be further reduced.

The surface hardness is more preferably 5 GPa or less, still more preferably 1 GPa or less.

The lower limit of the surface hardness is not limited and is for example 0.1 GPa or 0.2 GPa, preferably 0.3 GPa.

The surface hardness of the organic film measured by a nanoindenter can be adjusted by adjusting the type of the resin component constituting the organic film or the composition of the organic film. Specifically, for example, the surface hardness can be increased by introducing a rigid skeleton having a high glass transition temperature or adding an inorganic filler. The surface hardness can be decreased by using a compound that has a rigid skeleton having a low glass transition temperature or an organosilicon compound described later.

The nanoindenter as used herein is a device that measures hardness based on the relation between the force applied to insert an indenter to a sample surface and the stress. The nanoindenter can measure the hardness of a sample. For example, the surface hardness may be measured by the following method.

A side surface (stacking surface) of the stack is embedded in a cold mounting resin and the resin is ground using a cross-section grinding device until the organic film is exposed. The surface hardness can be obtained by performing measurement under the conditions that the sample is indented to 1,000 nm using a nanoindenter (TI 950 TriboIndenter produced by Scienta Omicron, Inc. or its equivalent) at a measurement temperature of 23°C and a rate of 200 nm measured displacement/sec and then the measurement probe is pulled out at a rate of 200 nm/sec. The measurement probe used is a Berkovich diamond indenter.

The organic film may have any thickness and preferably each have a thickness of 10 um or greater and 300 um or less.

The organic film having a thickness within the range can further exhibit the function as an insulating layer while further reducing misalignment or cracking of electrodes. The thickness of the organic film is more preferably 20 um or greater, still more preferably 30 um or greater and is more preferably 200 um or less, still more preferably 100 um or less.

The organic film preferably contains an organosilicon compound. The organosilicon compound preferably has a structure represented by the following formula (1). The use of an organosilicon compound can further reduce misalignment or cracking of electrodes. Organosilicon compounds have excellent heat resistance, so that they can further reduce the decomposition of the organic film due to high-temperature processing performed in the production of the stack or an electronic component including the stack. In particular, to further improve heat resistance and further reduce misalignment or cracking of electrodes, the organosilicon compound more preferably further has an aromatic ring structure.

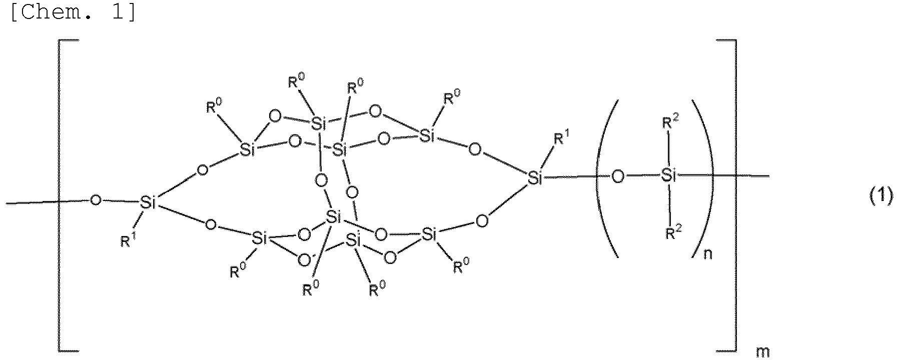

Here, each R⁰, R¹, and R² independently represents a linear, branched, or cyclic aliphatic group, an aromatic group, or hydrogen; the aliphatic group and the aromatic group may or may not have a substituent; and m and n each represent an integer of 1 or greater.

In the formula (1), each R⁰ independently represents a linear, branched, or cyclic aliphatic group, an aromatic group, or hydrogen; the aliphatic group and the aromatic group may or may not have a substituent; and each R⁰ is preferably a phenyl group, a C1-C20 alkyl group, or an arylalkyl group, more preferably a phenyl group. When each R⁰ is a phenyl group, a C1-C20 alkyl group, or an arylalkyl group, the organosilicon compound can exhibit higher heat resistance.

In the formula (1), each R¹ and R² independently represents a linear, branched, or cyclic aliphatic group, an aromatic group, or hydrogen; the aliphatic group and the aromatic group may or may not have a substituent; and each R¹ and R² is preferably a phenyl group, a C1-C20 alkyl group, or an arylalkyl group, more preferably a phenyl group or a methyl group. When each R¹ and R² is a phenyl group, a C1-C20 alkyl group, or an arylalkyl group, the organosilicon compound can exhibit higher heat resistance.

In the formula (1), m and n are each an integer of 1 or greater and represent the number of repeating units; m is preferably 30 or greater, more preferably 50 or greater and is preferably 100 or less; and n is preferably 1 or greater, more preferably 3 or greater and is preferably 8 or less.

The organic film is preferably a cured product of a curable resin composition.

Using a curable resin composition as the material of the organic film enables formation of the organic film by applying the curable resin composition and then curing the resulting film. Using a curable resin composition thus can improve the production efficiency as compared with using a conventional inorganic material. The curable resin constituting the curable resin composition may be thermosetting or photocurable, and is preferably a thermosetting resin from the viewpoint of heat resistance.

The curable resin composition preferably contains a reactive site-containing organosilicon compound.

Using a reactive site-containing organosilicon compound as the curable resin of the curable resin composition can further reduce misalignment or cracking of electrodes. Moreover, organosilicon compounds have excellent heat resistance, so that they can further reduce the decomposition of the organic film due to high-temperature processing performed in the production of the stack or an electronic component including the stack. Examples of the reactive site include a hydroxy group and an alkoxy group.

The amount of the reactive site-containing organosilicon compound in 100 parts by weight of the amount of resin solids in the curable resin composition is preferably 80 parts by weight or more, more preferably 90 parts by weight or more, still more preferably 95 parts by weight or more. The amount of the reactive site-containing organosilicon compound in 100 parts by weight of the amount of resin solids in the curable resin composition is preferably less than 100 parts by weight, more preferably 98 parts by weight or less.

The reactive site-containing organosilicon compound preferably has a structure represented by the following formula (1).

Using such a reactive site-containing organosilicon compound can further reduce misalignment or cracking of electrodes. In particular, to even further reduce misalignment or cracking of electrodes, the reactive site-containing organosilicon compound more preferably has an aromatic ring structure. 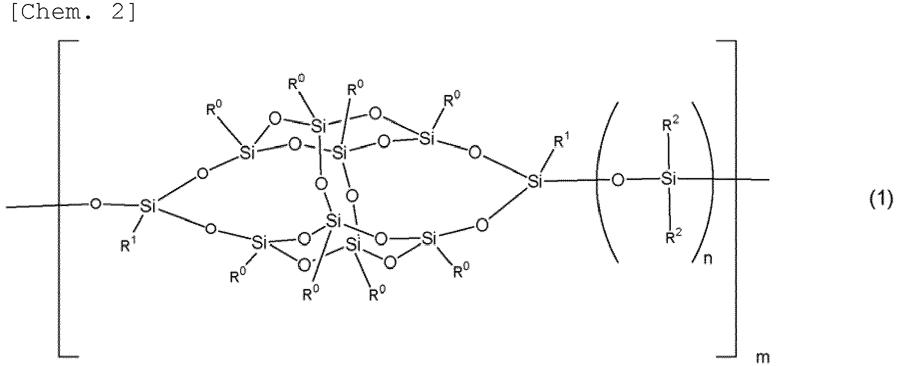 Here, each R⁰, R¹, and R² independently represents a linear, branched, or cyclic aliphatic group, an aromatic group, or hydrogen; the aliphatic group and the aromatic group may or may not have a substituent; and m and n each represent an integer of 1 or greater.

In the formula (1), each R⁰ independently represents a linear, branched, or cyclic aliphatic group, an aromatic group, or hydrogen; the aliphatic group and the aromatic group may or may not have a substituent; and each R⁰ is preferably a phenyl group, a C1-C20 alkyl group, or an arylalkyl group, more preferably a phenyl group. When each R⁰ is a phenyl group, a C1-C20 alkyl group, or an arylalkyl group, the organosilicon compound can have higher heat resistance.

In the formula (1), each R¹ and R² independently represents a linear, branched, or cyclic aliphatic group, an aromatic group, or hydrogen; the aliphatic group and the aromatic group may or may not have a substituent; and each R¹ and R² is preferably a phenyl group, a C1-C20 alkyl group, or an arylalkyl group, more preferably a phenyl group or a methyl group. When each R¹ and R² is a phenyl group, a C1-C20 alkyl group, or an arylalkyl group, the organosilicon compound can have higher heat resistance.

In the formula (1), m and n are each an integer of 1 or greater and represent the number of repeating units; m is preferably 30 or greater, more preferably 50 or greater and is preferably 100 or less; and n is preferably 1 or greater, more preferably 3 or greater and is preferably 8 or less.

A cured product of the curable resin composition preferably has a tensile modulus of elasticity at 25°C of 5 GPa or less. A cured product having a tensile modulus of elasticity within the range has higher flexibility and thus can further reduce the occurrence of warping of the substrates and the stack and in turn misalignment or cracking of electrodes. The tensile modulus of elasticity is more preferably 1 GPa or less, still more preferably 700 MPa or less, further preferably 500 MPa or less. The lower limit of the tensile modulus of elasticity is not limited and is preferably 100 MPa or greater for secure bonding of the substrates. Here, the tensile modulus of elasticity can be measured using a dynamic viscoelastic analyzer (e.g., DVA-200 produced by IT Measurement Co., Ltd.). Specifically, when the curable resin composition is thermosetting, the curable resin composition is heated at 70°C for 30 minutes, then at 90°C for one hour to evaporate off the solvent, and further heated at 200°C for one hour to cure the curable resin composition. The tensile modulus of elasticity is then measured under the conditions of a constant-rate heating tensile mode, a heating rate of 10°C/min, and a frequency of 10 Hz. When the curable resin composition is photocurable, the curable resin composition is heated at 70°C for 30 minutes and then further heated at 90°C for one hour to evaporate off the solvent. Then, 405 nm UV is applied at a dose of 3,000 mJ/cm² to cure the curable resin composition, and then the tensile modulus of elasticity can be measured under the same measurement conditions as the thermosetting resin composition.

The tensile modulus of elasticity at 25°C can be adjusted by adjusting the composition of the curable resin composition or the type of the curable resin.

Specifically, for example, the tensile modulus of elasticity can be increased by introducing a rigid skeleton having a high glass transition temperature or adding an inorganic filler. The tensile modulus of elasticity can be decreased by using a compound that has a rigid skeleton having a low glass transition temperature or the organosilicon compound described above.

The curable resin may have any weight average molecular weight and preferably has a weight average molecular weight of 5,000 or greater and 150,000 or less. The curable resin having a molecular weight within the range increases the film formability in application, which can lead to further reduction in misalignment or cracking of electrodes. The molecular weight of the curable resin is more preferably 10,000 or greater, still more preferably 30,000 or greater and is more preferably 100,000 or less, still more preferably 70,000 or less.

The weight average molecular weight of the curable resin is measured by gel permeation chromatography (GPC) as a polystyrene equivalent molecular weight. THF is used as an elution solvent, and HR-MB-M 6.0 × 150 mm (produced by Waters Corporation) or its equivalent is used as a column. The weight average molecular weight can be calculated using polystyrene standards.

The compound having a structure of the formula (1) can be obtained by, for example, reacting a compound (2) represented by the following formula (2) with a compound (3) represented by the following formula (3). 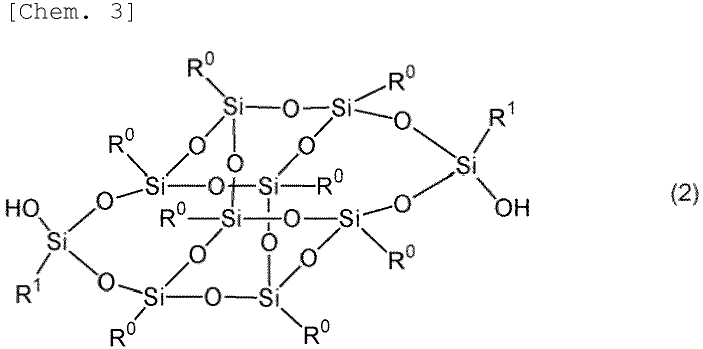 In the formula (2), R⁰s and R¹s represent the same functional groups as R⁰s and R¹s in the formula (1). 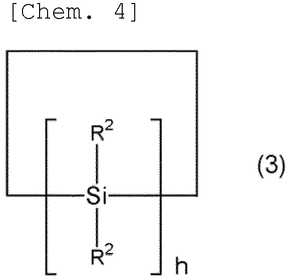 In the formula (3), R₂'s represent the same functional groups as R₂'s in the formula (1). In the formula (3), h represents a natural number, preferably 3 to 6, more preferably 3 or 4.

The compound having a structure of the formula (1) can also be obtained by reacting the compound (2) with halogenated siloxane having R² (e.g., dimethyl siloxane having a chlorinated terminal) instead of the compound (3).

The compound (2) can be obtained by, for example, reacting a salt such as a compound (4) represented by the following formula (4) with a compound (5) represented by the following formula (5). The compound (2) can also be obtained by reacting the compound (5) wherein X is hydrogen with the compound (4) followed by hydrolysis. 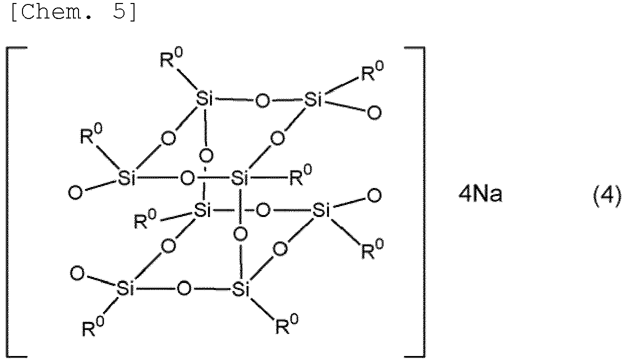 In the formula (4), R⁰s represent the same functional groups as R⁰s and R¹s in the formula (1). 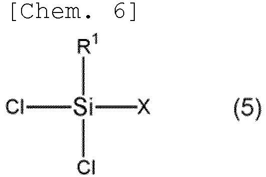 In the formula (5), R¹ represents the same functional group as R¹s in the formula (1); and X represents hydrogen or a hydroxy group.

The compound (4) can be produced by, for example, hydrolysis and polycondensation of a compound (6) represented by the following formula (6) in the presence of a monovalent alkali metal hydroxide and water and in the presence or absence of an organic solvent. The monovalent alkali metal hydroxide used may be lithium hydroxide, sodium hydroxide, potassium hydroxide, cesium hydroxide, or the like. 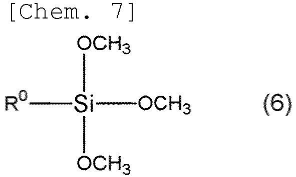 In the formula (6), R⁰ represents the same functional group as R⁰s in the formula (1).

The curable resin composition preferably contains a catalyst that promotes curing reaction.

The curable resin composition containing a catalyst enables more complete curing of the curable resin, which can further reduce the decomposition of the organic film due to high-temperature processing.

Examples of the catalyst include: organotin compounds such as dibutyltin dilaurate and tin(II) acetate; metal carboxylates such as zinc naphthenate; zirconia compounds; and titanium compounds. Preferred among these is dibutyltin dilaurate because it can further promote curing of the curable resin composition.

The catalyst still exists after the curable resin composition is cured. In other words, the organic film preferably contains a catalyst that promotes curing reaction.

The amount of the catalyst is not limited and is preferably 0.01 parts by weight or more and 10 parts by weight or less relative to 100 parts by weight of the curable resin in the curable resin composition. The catalyst contained in an amount within the range can further promote curing of the curable resin composition. The amount of the catalyst is more preferably 0.1 parts by weight or more, still more preferably 1 part by weight or more and is more preferably 7 parts by weight or less, still more preferably 5 parts by weight or less.

The curable resin composition preferably contains a polyfunctional crosslinking agent capable of reacting with a reactive site of the reactive site-containing organosilicon compound.

Crosslinking between the polymer chains of the reactive site-containing organosilicon compound by a polyfunctional crosslinking agent capable of reacting with a reactive site of the organosilicon compound increases the crosslinking density of the cured product, thus further reducing the decomposition at high temperature. As a result, the generation of voids due to the generation of decomposed gas during high-temperature processing, as well as the resulting misalignment of electrodes in bonding and reduction in electrical connection reliability, can be further prevented. Examples of the polyfunctional crosslinking agent in the case where the reactive site is a silanol group include alkoxysilane compounds such as dimethoxysilane compounds, trimethoxysilane compounds, diethoxysilane compounds, and triethoxysilane compounds and silicate oligomers obtained by condensation of a tetramethoxysilane compound and a tetraethoxysilane compound. In particular, for improvement in the crosslinking density and heat resistance, silicate oligomers are preferred. Examples of alkoxysilane compounds include dimethoxydimethylsilane, trimethoxymethylsilane, tetraethoxysilane, tetrapropoxysilane, and tetrabutoxysilane. Examples of silicate oligomers include silicate MS51, MS56, MS57, and MS56S (all produced by Mitsubishi Chemical Corporation) and ethyl silicate 40, ethyl silicate 48, and EMS 485 (all produced by Colcoat Co., Ltd.).

The amount of the polyfunctional crosslinking agent is not limited and is preferably 1 part by weight or more and 50 parts by weight or less relative to 100 parts by weight of the curable resin in the curable resin composition. The polyfunctional crosslinking agent contained in an amount within the range allows the organic film to have a crosslinking density within a suitable range and also to have a hardness within the above-described range after heat treatment. The amount of the polyfunctional crosslinking agent is more preferably 3 parts by weight or more, still more preferably 5 parts by weight or more and is more preferably 30 parts by weight or less, still more preferably 20 parts by weight or less.

The curable resin composition may contain other additives such as a viscosity modifier, a filler, and an adhesion-imparting agent, as necessary.

The stack of the present invention includes the organic film obtained by curing the curable resin composition. The stack thus has high electrical connection reliability.

The present invention also encompasses such a curable resin composition used for forming an organic film of a stack, the stack sequentially including a first substrate having an electrode, the organic film, and a second substrate having an electrode, the electrode of the first substrate and the electrode of the second substrate being electrically connected via a through-hole extending through the organic film.

The stack of the present invention preferably includes an inorganic layer having a thickness of 1 nm or greater and 1 um or less between the first substrate and the second substrate.

Providing an inorganic layer between the first substrate and the second substrate increases insulation, resulting in a stack having better connection reliability. Conventional stacks have an inorganic material insulating layer having a thickness of about 10 to 20 um, and thus cannot eliminate warping of the substrates and the stack, leading to a reduction in connection reliability. The inorganic layer in one embodiment of the present invention is as thin as 1 um or less, so that warping of the substrates and the stack can be eliminated even when the inorganic layer is provided.

The material of the inorganic layer is not limited. Examples thereof include SiN, SiO₂, and Al₂O₃. Preferred among these are SiN and SiO₂ because they have excellent insulation and heat resistance.

To further increase the connection reliability of the stack, the inorganic layer has a thickness of more preferably 5 nm or greater, still more preferably 10 nm or greater and more preferably 500 nm or less, still more preferably 100 nm or less.

The stack of the present invention preferably includes a barrier metal layer on a surface of the through-hole.

The barrier metal layer serves to prevent the conductive material (e.g., Cu atoms in the case of Cu electrode) filling the through-hole from diffusing into the organic film. The barrier metal layer provided on the surface of the through-hole covers the conductive material filling the through-hole except for the surfaces that contact the electrodes. This can further reduce short circuiting and conduction failure caused by the diffusion of the conductive material into the organic film. The material of the barrier metal layer may be a known material such as tantalum, tantalum nitride, or titanium nitride.

The barrier metal layer may have any thickness. To further increase the connection reliability of the stack, the barrier metal layer has a thickness of more preferably 1 nm or greater, still more preferably 10 nm or greater and more preferably 100 nm or less, still more preferably 50 nm or less.

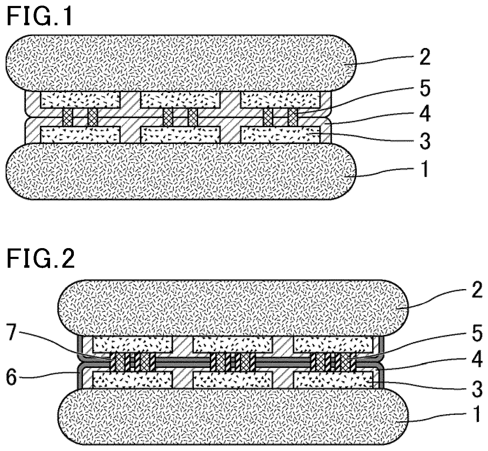

Fig. 1 is a schematic view of an embodiment of the stack of the present invention. As shown in Fig. 1, the stack of the present invention has the following structure. A first substrate 1 having electrodes 3 and a second substrate 2 having electrodes 3 are bonded to each other through organic films 4. The electrodes 3 on the first substrate 1 and the electrodes 3 on the second substrate 2 are electrically connected via a conductive material filling through-holes 5 formed in the organic films 4. Conventional stacks include a hard inorganic material in place of the organic films 4, as an insulating layer. Warping of the substrates and the stack thus cannot be eliminated by stress relaxation, so that misalignment or cracking of electrodes are more likely to occur. The present invention, which uses a flexible organic compound for the insulating layer, can eliminate warping of the substrates and the stack and thus reduce misalignment or cracking of electrodes.

Fig. 2 is a schematic view of an embodiment of the stack of the present invention. In the embodiment in Fig. 2, inorganic layers 6 are formed between the organic films 4, providing higher insulation. The inorganic layers 6 each have a thickness of 1 nm to 1 um. The inorganic layers 6 are thinner than insulating layers of conventional stacks and do not hinder the elimination of warping of the substrates or the stack. Although in Fig. 2 the inorganic layers 6 are formed between the organic films 4, they may be formed on the first substrate 1 and the second substrate 2. Although in Fig. 2 the inorganic layers 6 are formed on the respective organic films 4 on the first substrate 1 side and the second substrate 2 side, an inorganic film 6 may be formed on only one of the organic films 4. In the embodiment in Fig. 2, barrier metal layers 7 are formed on the surfaces of the through-holes 5. Forming barrier metal layers 7 on the surfaces of the through-holes 5 makes it difficult for the conductive material filling the through-holes 5 to diffuse into the organic films 4, and thus can further reduce short circuiting and conduction failure.

Examples of the method for producing the stack of the present invention include a production method including the steps of: forming an organic film on a surface of a first substrate having an electrode, the surface being a surface on which the electrode is formed; forming a through-hole in the organic film; filling the through-hole with a conductive material; forming a bonding electrode by polishing the surface of the substrate on the side where the through-hole is filled with the conductive material; and bonding the first substrate on which the bonding electrode is formed and a second substrate on which the bonding electrode is formed such that the bonding electrodes are bonded to each other. The present invention also encompasses such a method for producing a stack.

With the method for producing a stack of the present invention, first, the step of forming an organic film on a surface of a first substrate having an electrode is performed. The surface is a surface on which the electrode is formed.

The first substrate having an electrode, the second substrate having an electrode, and the organic film may be the same as the first substrate having an electrode, the second substrate having an electrode, and the organic film in the stack of the present invention.

The step of forming an organic film preferably includes the step of applying a curable resin composition, then evaporating off the solvent, and curing the curable resin composition.

The curable resin composition may be the same as the curable resin composition of the present invention.

The method for applying the curable resin composition is not limited. A conventionally known method such as a spin coating method may be used.

The conditions for evaporating off the solvent are not limited. To reduce residual solvent and improve the heat resistance of the organic film, heating is preferably performed at a temperature of preferably 70°C or higher, more preferably 100°C or higher and preferably 250°C or lower, more preferably 200°C or lower for, for example, about 30 minutes, more preferably about one hour.

The conditions for curing are not limited. To allow the curing reaction to sufficiently proceed and to further improve heat resistance, for a curable resin composition including a thermosetting resin, heating is preferably performed at a temperature of preferably 200°C or higher, more preferably 220°C or higher and preferably 400°C or lower, more preferably 300°C or lower for, for example, about one hour or longer, more preferably about two hours or longer. The upper limit of the heating time is not limited and is preferably three hours or shorter to reduce pyrolysis of the organic film. For a curable resin composition including a photocurable resin, 405 nm ultraviolet light is preferably applied at a dose of preferably 1,500 mJ/cm² or more, more preferably 3,000 mJ/cm² or more.

With the method for producing a stack of the present invention, subsequently, the step of forming a through-hole in the organic film is performed.

The through-hole may be patterned. The method for forming the through-hole is not limited. The through-hole can be formed by laser irradiation such as CO₂ laser irradiation or etching. When a different layer is formed on the electrode surface of the substrate, the through-hole is formed to extend through the different layer as well as the organic film so that the electrode surface of the substrate is exposed.

With the method for producing a stack of the present invention, the step of forming an inorganic layer and/or a barrier metal layer is performed, as necessary.

The inorganic layer and the barrier metal layer may be the same as those in the stack of the present invention. The inorganic layer and the barrier metal layer can be formed by sputtering or vapor deposition, for example.

The step of forming an inorganic layer is preferably performed before and/or after the step of forming an organic film. The barrier metal layer is preferably formed after the step of forming a through-hole.

With the method for producing a stack of the present invention, subsequently, the step of filling the through-hole with a conductive material is performed. The method of filling the through-hole with the conductive material may be plating, for example.

The conductive material may be the same as the conductive material in the stack of the present invention.

With the method for producing a stack of the present invention, subsequently, the step of forming a bonding electrode by polishing the surface of the substrate on the side where the through-hole is filled with the conductive material is performed.

Removing the conductive material formed on undesired portions by polishing forms a bonding electrode that connects the electrodes formed on the two substrates. The polishing preferably planarizes and removes the layer formed of the conductive material until the organic film is exposed or until the inorganic layer, when it is present, is exposed.

The method for polishing is not limited and may be a chemical mechanical polishing method, for example.

The present invention also encompasses such a method for producing a substrate having a bonding electrode, including the steps of: forming an organic film on a surface of a substrate having an electrode, the surface being a surface on which the electrode is formed; forming a through-hole in the organic film; filling the through-hole with the conductive material; and forming a bonding electrode by polishing the surface of the substrate.

The substrate having a bonding electrode is a component used for forming a stack by bonding it with another substrate having a bonding electrode such that the bonding electrodes between the substrates are bonded to each other. The descriptions for the substrate, the organic film, the curable resin composition, and other structures and the steps are the same as the descriptions for those in the stack, the curable resin composition, and the method for producing a stack of the present invention.

With the method for producing a stack of the present invention, subsequently, the step of bonding the first substrate on which the bonding electrode is formed and a second substrate on which the bonding electrode is formed such that the bonding electrodes are bonded to each other is performed.

The first substrate and the second substrate may be bonded by a method including connecting the electrodes and the bonding electrodes by melting them by heat treatment. The heat treatment is typically performed at about 400°C for about four hours.

The stack of the present invention may be used in any application. The stack has high electrical connection reliability and can particularly reduce warping of the substrates or the stack even when it includes thin substrates bonded to each other. The stack thus can be suitably used as a stack that constitutes a semiconductor device or an imaging device.

The present invention also encompasses such a semiconductor device including the stack of the present invention and such an imaging device including the stack of the present invention.

### - Advantageous Effects of Invention

The present invention can provide a stack having high electrical connection reliability, a curable resin composition used for the stack, a method for producing the stack, a method for producing a substrate having a bonding electrode used for producing the stack, a semiconductor device including the stack, and an imaging device including the stack.

### BRIEF DESCRIPTION OF DRAWINGS

Fig. 1 is a schematic view of an embodiment of the stack of the present invention.
Fig. 2 is a schematic view of an embodiment of the stack of the present invention.

### DESCRIPTION OF EMBODIMENTS

Embodiments of the present invention are more specifically described in the following with reference to examples. The present invention, however, is not limited to these examples.

### (Production of curable resin)

### (1) Production of POSS-A

A reaction vessel equipped with a reflux condenser, a thermometer, and a dropping funnel was charged with 320 g of phenyltrimethoxysilane (produced by Tokyo Chemical Industry Co., Ltd., molecular weight 198.29), 8.8 g of sodium hydroxide, 6.6 g of water, and 263 mL of 2-propanol. Heating was started under a nitrogen gas flow with stirring. Stirring was continued for six hours from the start of reflux, and the mixture was then left to stand overnight at room temperature. The reaction mixture was transferred into a filter and filtered by pressurization with nitrogen gas. The obtained solid was washed with 2-propyl alcohol once, filtered, and then dried at 80°C under reduced pressure to give 330 g of a colorless solid (DD-ONa).

Next, a reaction vessel equipped with a reflux condenser, a thermometer, and a dropping funnel was charged with 20 g of cyclopentyl methyl ether, 2.4 g of 2-propanol, 14 g of ion-exchanged water, and 7.25 g of dichloromethylsilane (produced by Tokyo Chemical Industry Co., Ltd., molecular weight 115.03). They were stirred in a nitrogen atmosphere at room temperature. Subsequently, 8 g of the compound (DD-ONa) obtained above and 20 g of cyclopentyl methyl ether were put into the dropping funnel, made into a slurry, and added dropwise into the reactor over 30 minutes. Stirring was continued for 30 minutes after the termination of the dropwise addition. After the reaction, stirring was terminated, and the mixture was left to stand to separate it into an organic phase and an aqueous phase. The organic phase was neutralized by washing with water, filtered through a membrane filter to remove impurities, and concentrated under reduced pressure at 60°C using a rotary evaporator to give a 9.5 g of a colorless solid. This colorless solid was washed with 10 g of methyl acetate and dried under reduced pressure to give 6.2 g of a colorless, powdery solid (DD(Me)-OH).

A 100-mL flask was equipped with a condenser, a mechanical stirrer, a Dean-Stark apparatus, an oil bath, and a thermometer protecting tube. The air inside the flask was purged with nitrogen. The flask was charged with 5.0 g of the DD(Me)-OH, 2.5 g of octamethylcyclotetrasiloxane (D4), 0.5 g of RCP-160M (strongly acidic cation exchange resin, produced by Mitsubishi Chemical Corporation, water content 23.4 mass%), and 51.0 mL of dehydrated toluene. The mixture was refluxed for one hour to recover 22.4 mL of toluene and 0.12 g of water contained in an amount of 23.4 mass% in the RCP-160M. After reflux, the temperature was cooled to 80°C, and 0.55 g of pure water was added, followed by aging at 80°C. The equilibrium was reached after five hours. After cooling to room temperature, RCP-160M was filtered out, and the obtained filtrate was washed with water once. The solvent and low-boiling components of the filtrate were then distilled off. The obtained crude product was reprecipitated in heptane for refinement, whereby an organosilicon compound (POSS-A, weight average molecular weight 130,000) having a structure of the following formula (7) wherein m2 is 55 and the average of n2 is 4 was obtained.

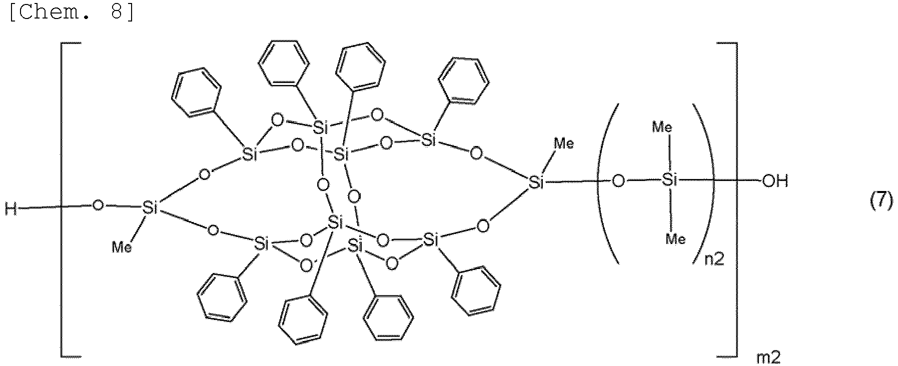

### (2) Production of POSS-B

An organosilicon compound (POSS-B, weight average molecular weight 130,000) having a structure of the formula (2) wherein m2 is 38 and the average of n2 is 8 was obtained as in the production of POSS-A, except that the amount of octamethylcyclotetrasiloxane added was 5.0 g.

### (3) Production of POSS-C

An organosilicon compound (POSS-C, weight average molecular weight 90,000) having a structure of the formula (2) wherein m2 is 50 and the average of n2 is 2 was obtained as in the production of POSS-A, except that the amount of octamethylcyclotetrasiloxane added was 1.5 g.

### (4) Production of POSS-D

An organosilicon compound (POSS-D, weight average molecular weight 110,000) having a structure of the following formula (8) wherein m2 is 60 and the average of n2 is 4 was obtained as in the production of POSS-A, except that phenyltrimethoxysilane was changed to methyltrimethoxysilane (produced by Tokyo Chemical Industry Co., Ltd., molecular weight 136.22) and the amount of methyltrimethoxysilane added was 210 g.

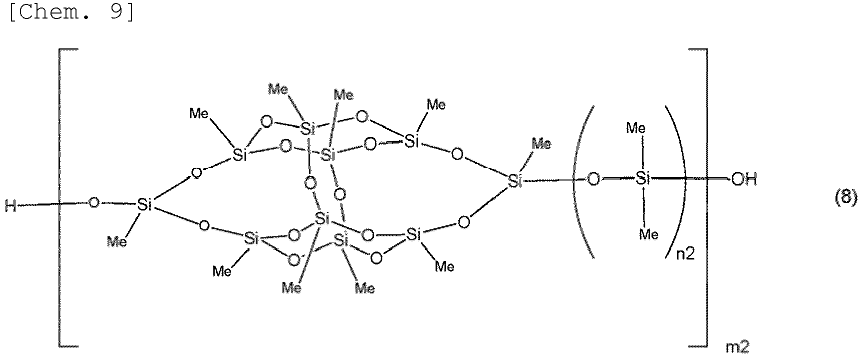

### (5) POSS-E

SR-13 produced by Konishi Chemical Ind. Co., Ltd. was used. SR-13 is a silsesquioxane compound that does not satisfy the formula (1).

### (6) POSS-F

SR-33 produced by Konishi Chemical Ind. Co., Ltd. was used. SR-33 is silsesquioxane having an aromatic ring group and not satisfying the formula (1).

### (7) PDMS resin

KR-255 produced by Shin-Etsu Chemical Co., Ltd. was used as a PDMS resin.

### (8) Production of wafer 1

Films of SiO (500 nm), SiCN (50 nm), and SiO (250 nm) were sequentially formed on a 12-inch silicon wafer by plasma CVD. The SiO layer (250 nm) as the front layer was etched using a photomask. Subsequently, a Ta layer (50 nm) was formed and a TaN (10 nm) layer was further formed thereon, whereby barrier metal layers were formed. This was followed by Cu plating and planarization by CMP to form an electrode pattern. On the electrode pattern was formed a SiCN layer (50 nm) and a SiO layer (500 nm) by plasma CVD, whereby a wafer 1 having electrodes were obtained.

### (9) Production of wafer 2

A wafer 2 was produced as in the production of the wafer 1, except that the wafer 2 was patterned such that the opposing bonding electrodes and the electrodes formed on the wafers would form daisy chains when the wafers were bonded.

### (Example 1)

A hundred parts by weight of the obtained POSS-A, 0.1 parts by weight of dibutyltin dilaurate as a catalyst, and 1 part by weight of silicate MS51 (produced by Mitsubishi Chemical Corporation) as a crosslinking agent were dissolved in propylene glycol monoethyl acetate and mixed such that the amount of resin solids was 50%, whereby a curable resin composition solution was obtained.

Subsequently, the obtained curable resin composition solution was applied, with a spin coater, to the surface of the wafer 1 on which the electrodes were formed, heated at 70°C for 30 minutes and then at 90°C for one hour to evaporate off the solvent, and further heated at 200°C for one hour to form an organic film having a thickness of 20 um on the electrode surface of the wafer 1. A SiN layer (500 nm) was then formed by plasma CVD. Subsequently, the SiN layer and the organic film as well as the SiO layer (500 nm) and the SiCN layer (50 nm) on the electrode surface of the wafer 1 were etched using a photomask to form through-holes on the electrodes of the wafer 1. Here, the diameter of the etched vias was 20 um, and the pitch between adjacent vias was 40 um. Subsequently, a Ta layer (50 nm) was formed and a TaN layer (10 nm) was further formed thereon, whereby barrier metal layers were formed. Cu plating was then performed to fill the through-holes with a conductive material. Subsequently, the surface of the wafer 1 on the Cu-plated side (the surface of the wafer 1 on the side where the organic film was stacked) was polished to remove unnecessary portions of the barrier layers and the conductive material, whereby bonding electrodes were formed.

Separately, an organic film and bonding electrodes were formed also on the wafer 2 as in the production of the wafer 1, except that the wafer 2 was patterned such that the opposing electrodes would form daisy chains.

The wafer 1 and wafer 2 were then subjected to H₂ plasma cleaning, and the two substrates were bonded in vacuum such that the bonding electrodes were superimposed on each other. The substrates were heat-treated at 400°C for four hours, whereby a stack was obtained.

### (Examples 2 to 8)

A stack was obtained as in Example 1, except that the type of the curable resin and the presence or absence of the catalyst were as shown in Table 1.

### (Example 9)

A stack was obtained as in Example 5, except that the amount of silicate MS51 (produced by Mitsubishi Chemical Corporation) as a crosslinking agent was 3.2 parts by weight.

### (Example 10)

A stack was obtained as in Example 5, except that the amount of silicate MS51 (produced by Mitsubishi Chemical Corporation) as a crosslinking agent was 16 parts by weight.

### (Example 11)

A stack was obtained as in Example 5, except that the amount of silicate MS51 (produced by Mitsubishi Chemical Corporation) as a crosslinking agent was 32 parts by weight.

### (Example 12)

A stack was obtained as in Example 1, except that no SiN layer (500 nm) was formed after the organic films were formed.

### (Comparative Example 1)

A stack was obtained as in Example 1, except that an inorganic layer (20 um) made of Si₃N₄ was formed by plasma CVD on the surface of the wafer 1 on which the electrodes were formed, and that the inorganic layer was used as a substitute for the organic film. The specific conditions for plasma CVD were as follows.
Raw material gas: SiH₄ gas and nitrogen gas
Flow rate: SiH₄ gas 10 sccm, nitrogen gas 200 sccm
RF power: 10 W (frequency 2.45 GHz)
Temperature inside chamber: 100°C
Pressure inside chamber: 0.9 Torr

### (Comparative Example 2)

A stack was obtained as in Comparative Example 1 except that SiH₄ gas and oxygen gas were used as raw material gases, and that the plasma CVD target was changed to SiO₂ to form an inorganic layer (20 um) made of SiO₂.

### (Measurement of weight loss)

Single layers of organic films and single layers of inorganic layers were produced by the above methods. The obtained single layers were each heated using a thermogravimetry-differential thermal analyzer (TG-DTA: STA7200, produced by Hitachi High-Tech Science Corporation) under a nitrogen flow (50 mL/min) from 25°C to 400°C at a heating rate of 10°C/min, and the weight loss when the single layer was held at 400°C for four hours was measured. Table 1 shows the results.

### (Measurement of surface hardness)

A side surface of each of the obtained stacks was embedded in a cold mounting resin, and the resin was ground to expose the organic films or the inorganic layers at the side surface. The measurement was then performed under the conditions that the sample is indented to 1,000 nm using a nanoindenter (TI 950 TriboIndenter produced by Scienta Omicron, Inc.) at a rate of 200 nm measured displacement/sec and then the measurement probe is pulled out at a rate of 200 nm/sec. Thus, an indentation curve for the organic films or the inorganic layers was obtained. The measurement probe used was a Berkovich diamond indenter. From the obtained indentation curve, the surface nanoindentation hardness was calculated in conformity with ISO14577, whereby the surface hardness was determined. The constant ε related to the indenter shape was 0.75 (ε = 0.75). Table 1 shows the results.

### (Evaluation of tensile modulus of elasticity)

Single layers of organic films and single layers of inorganic layers were produced by the above methods. The tensile modulus of elasticity of each of the obtained single layers was measured under the conditions of a constant-rate heating tensile mode, a heating rate of 10°C/min, and a frequency of 10 Hz using a dynamic viscoelastic analyzer (DVA-200 produced by IT Measurement Co., Ltd.).

### <Evaluation>

The stacks obtained in the examples and the comparative examples were evaluated as follows. Table 1 shows the results.

### (Evaluation of connection reliability)

In each of the stacks obtained in the examples and the comparative examples, electrodes located at a wafer center portion, 5 cm away from the wafer center, and 10 cm away from the wafer center were examined for the current conduction. The initial connection reliability was evaluated in accordance with the following criteria. The electrodes at each of the locations formed a daisy chain consisting of 10 × 10 electrodes.
o (Good): There was conduction at all the locations after the bonding of the wafers.
× (Poor): There was conduction failure at some of the locations after the bonding of the wafers.

Subsequently, the stack was left to stand at -40°C for 30 minutes, subsequently heated to 125°C, and left to stand for 30 minutes. These operations were defined as one set, and 100 sets or 300 sets were performed (reliability test). Thereafter, the same evaluation as for the initial connection reliability was performed to evaluate the connection reliability after reliability test ∘∘ (Excellent): There was conduction at all the locations after 300 sets.
∘ (Good): There was conduction at all the locations after 100 sets, but there was conduction failure at some of the locations after 300 sets.
× (Poor): There was conduction failure at some of the locations after 100 sets.

### (Evaluation of adhesion reliability)

The delamination area of electrode portions located at a wafer center portion, 5 cm away from the wafer center, and 10 cm away from the wafer center was measured using an ultrasonic imaging device. Based on the obtained delamination area, the adhesion reliability was evaluated in accordance with the following criteria. This evaluation was performed for each of the stack before the reliability test (initial) and the stack after the reliability test (100 sets).
∘∘ (Excellent): The delamination area was less than 5%.
∘ (Good): The delamination area was 5% or greater and less than 30%.
× (Poor): The delamination area was 30% or greater.

**[Table 1]**

| | | Example 1 | Example 2 | Example 3 | Example 4 | Example 5 | Example 6 | Example 7 | Example 8 | Example 9 | Example 10 | Example 11 | Example 12 | Comparative Example 1 | Comparative Example 2 |
|---|---|---|---|---|---|---|---|---|---|---|---|---|---|---|---|
| Curable resin | | POSS-A | POSS-A | POSS-B | POSS-C | POSS-D | POSS-E | POSS-F | PDMS resin | POSS-D | POSS-D | POSS-D | POSS-A | Si₃N₄ | SiO₂ |
| Cosslinking agent | | 1.0 | 1.0 | 1.0 | 1.0 | 1.0 | 1.0 | 1.0 | 1.0 | 3.2 | 16.0 | 32.0 | 1.0 | - | - |
| Catalyst | | 1.0 | 00 | 0.0 | 1.0 | 1.0 | 00 | 00 | 00 | 1.0 | 1.0 | 1.0 | 1.0 | - | - |
| Weight loss (%) | | 3.0 | 50 | >5.0 | 40 | 4.0 | >5.0 | >5.0 | >10.0 | 4.0 | 6.0 | 8.0 | 3.0 | 00 | 00 |
| Surface hardness (Gpa) | | 0.5 | 0.3 | 0.3 | 0.8 | 0.9 | 0.8 | 0.3 | 0.2 | 0.9 | 0.5 | 0.5 | 0.5 | 9.8 | 14.0 |
| Tensile modulus of elasticity (GPa) | | 0.4 | 0.3 | 0.2 | 0.5 | 0.7 | 0.5 | 0.4 | 0.2 | 0.9 | 0.6 | 0.6 | 0.4 | 700 | 290.0 |
| Inorganic layer | | Present | Present | Present | Present | Present | Present | Present | Present | Present | Present | Present | Absent | Present | Present |
| Connection reliability | Initial | ○ | ○ | ○ | ○ | ○ | ○ | ○ | ○ | ○ | ○ | ○ | ○ | ○ | ○ |
| | After reliability test | ○○ | ○○ | ○○ | ○○ | ○○ | ○○ | ○○ | ○○ | ○○ | ○○ | ○○ | ○ | × | × |
| Adhesion reliability | Initial | ○○ | ○○ | ○○ | ○○ | ○○ | ○○ | ○○ | ○ | ○○ | ○○ | ○○ | ○○ | ○○ | ○○ |
| | After reliability test | ○○ | ○ | ○ | ○ | ○ | ○ | ○ | ○ | ○ | ○ | ○ | ○ | × | × |

### INDUSTRIAL APPLICABILITY

The present invention can provide a stack having high electrical connection reliability, a curable resin composition used for the stack, a method for producing the stack, a method for producing a substrate having a bonding electrode used for producing the stack, a semiconductor device including the stack, and an imaging device including the stack.

### REFERENCE SIGNS LIST

- 1: first substrate
- 2: second substrate
- 3: electrode
- 4: organic film
- 5: through-hole
- 6: inorganic layer
- 7: barrier metal layer

## Claims

1. A stack sequentially comprising:
a first substrate having an electrode;
an organic film; and
a second substrate having an electrode,
the electrode of the first substrate and the electrode of the second substrate being electrically connected via a through-hole extending through the organic film.

2. The stack according to claim 1,
wherein the organic film has a weight loss of 5% or less after heat treatment at 400°C for four hours.

3. The stack according to claim 1 or 2,
wherein the organic film has a surface hardness of 5 GPa or less as measured using a nanoindenter.

4. The stack according to any one of claims 1 to 3,
wherein the organic film is a cured product of a curable resin composition.

5. The stack according to claim 4,
wherein the organic film contains an organosilicon compound.

6. The stack according to claim 5,
wherein the organosilicon compound has a structure represented by the following formula (1): 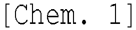 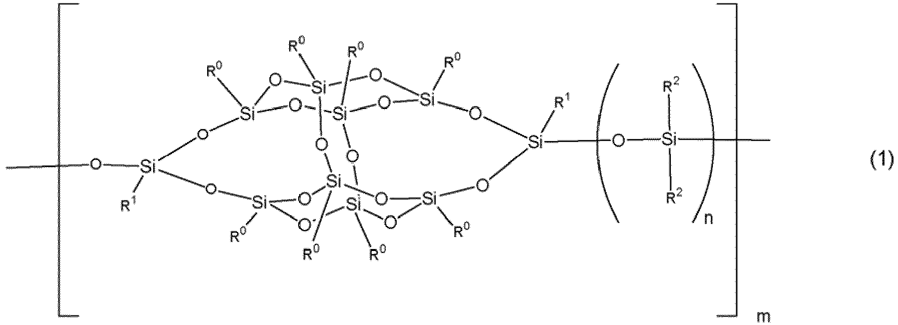 wherein each R⁰, R¹, and R² independently represents a linear, branched, or cyclic aliphatic group, an aromatic group, or hydrogen; the aliphatic group and the aromatic group may or may not have a substituent; and m and n each represent an integer of 1 or greater.

7. The stack according to claim 5 or 6,
wherein the organosilicon compound has an aromatic ring structure.

8. The stack according to any one of claims 1 to 7,
wherein the organic film contains a catalyst that promotes curing reaction.

9. The stack according to any one of claims 1 to 8, including an inorganic layer having a thickness of 1 nm or greater and 1 um or less between the first substrate and the second substrate.

10. The stack according to any one of claims 1 to 9, including a barrier metal layer on a surface of the through-hole.

11. A curable resin composition used for forming an organic film of a stack, the stack sequentially including a first substrate having an electrode, the organic film, and a second substrate having an electrode, the electrode of the first substrate and the electrode of the second substrate being electrically connected via a through-hole extending through the organic film.

12. The curable resin composition according to claim 11,
wherein a cured product of the curable resin composition has a tensile modulus of elasticity at 25°C of 1 GPa or less.

13. The curable resin composition according to claim 11 or 12, containing a reactive site-containing organosilicon compound.

14. The curable resin composition according to claim 13,
wherein the reactive site-containing organosilicon compound has a structure represented by the following formula (1): 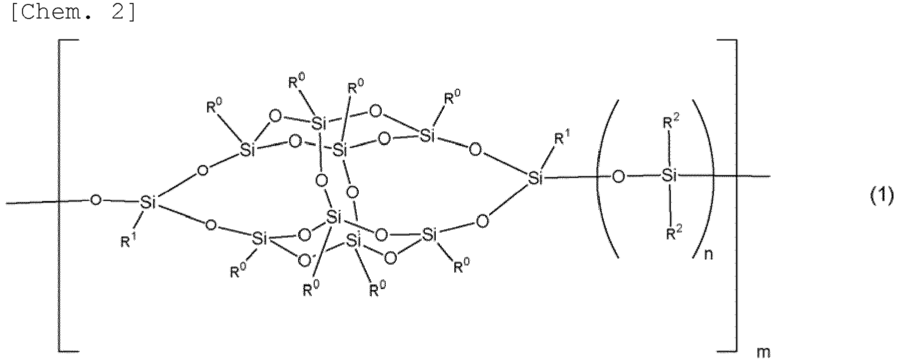 wherein each R⁰, R¹, and R² independently represents a linear, branched, or cyclic aliphatic group, an aromatic group, or hydrogen; the aliphatic group and the aromatic group may or may not have a substituent; and m and n each represent an integer of 1 or greater.

15. The curable resin composition according to claim 13 or 14,
wherein the organosilicon compound has an aromatic ring structure.

16. The curable resin composition according to any one of claims 13 to 15,
wherein the reactive site-containing organosilicon compound is contained in an amount of 90 parts by weight or more and 98 parts by weight or less in 100 parts by weight of an amount of resin solids in the curable resin composition.

17. The curable resin composition according to any one of claims 11 to 16, containing a catalyst that promotes curing reaction.

18. The curable resin composition according to any one of claims 13 to 17, containing a polyfunctional crosslinking agent capable of reacting with a reactive site of the reactive site-containing organosilicon compound.

19. A method for producing a stack, comprising the steps of:
forming an organic film on a surface of a first substrate having an electrode, the surface being a surface on which the electrode is formed;
forming a through-hole in the organic film;
filling the through-hole with a conductive material;
forming a bonding electrode by polishing the surface of the substrate on the side where the through-hole is filled with the conductive material; and
bonding the first substrate on which the bonding electrode is formed and a second substrate on which the bonding electrode is formed such that the bonding electrodes are bonded to each other.

20. A method for producing a substrate having a bonding electrode, comprising the steps of:
forming an organic film on a surface of a substrate having an electrode, the surface being a surface on which the electrode is formed;
forming a through-hole in the organic film;
filling the through-hole with a conductive material; and
forming a bonding electrode by polishing the surface of the substrate.

21. A semiconductor device comprising the stack according to any one of claims 1 to 10.

22. An imaging device comprising the stack according to any one of claims 1 to 10.
